# EUROPEAN PATENT APPLICATION

(11) **EP 4 773 171 A1**
(43) Date of publication of application: **08.07.2026**
(21) Application number: 24859979.7
(22) Date of filing: 30.08.2024
(51) Int. Cl.: H01L 21/308, C09K 13/06, G03F 7/40, H01L 21/304

(54) **SEMICONDUCTOR PROCESSING SOLUTION AND METHOD FOR USING SAME AS LOW-TOXICITY SEMICONDUCTOR PROCESSING SOLUTION**

(30) Priority: 01.09.2023 JP 2023142386
(71) Applicant: Tokuyama Corporation, Shunan-shi, Yamaguchi 745-8648 (JP)
(72) Inventor: KIKKAWA, Yuki, Shunan-shi, Yamaguchi 745-8648 (JP); SATO, Tomoaki, Shunan-shi, Yamaguchi 745-8648 (JP); SUZUKI, Yuzan, Shunan-shi, Yamaguchi 745-8648 (JP)
(74) Representative: Hoffmann Eitle
(86) International application number: PCT/JP2024/031287
(87) International publication number: WO 2025/047954

(57) **Abstract**

Provided is a semiconductor processing solution containing the following (A) to (E): (A) a quaternary ammonium ion represented by formula (1); (B) a halide ion; (C) a hydroxide ion; (D) an oxidizer; and (E) water. (In the formula, R¹, R², R³, and R⁴ are each independently a C1-16 alkyl group, provided that the number of carbon atoms in at least one alkyl group among R¹, R², R³, and R⁴ is 2-16.)

## Description

### Technical Field

The present invention relates to a semiconductor treatment liquid and a method of using the semiconductor treatment liquid as a low-toxicity semiconductor treatment liquid. More specifically, the present invention relates to a semiconductor treatment liquid containing a predetermined quaternary ammonium ion, a halide ion, a hydroxide ion, an oxidizing agent, and water.

### Background Art

Quaternary ammonium compounds are used in phase-transfer catalysts, surfactants, disinfectants and the like. Among the quaternary ammonium compounds, tetramethylammonium hydroxide is particularly used as a kind of strong organic base in semiconductor treatment liquids used in cleaning, etching, developing solutions and the like during semiconductor manufacturing.

For example, Patent Document 1 discloses a treatment liquid for a semiconductor with ruthenium, the treatment liquid containing a hypobromite ion.

### Prior Art Documents

### Patent Document

Patent Document 1: WO 2021/059666

### Summary of Invention

### Technical Problem

Examples of Patent Document 1 disclose a treatment liquid for a semiconductor with ruthenium, the treatment liquid using tetramethylammonium hydroxide as a basic compound. However, the present inventors have focused on the fact that an aqueous tetramethylammonium hydroxide (hereinafter also referred to as TMAH) solution is highly toxic and requires careful handling. In addition, it has been found that a semiconductor treatment liquid containing an oxidizing agent can remove or process a transition metal by oxidative dissolution (etching) of the transition metal with the oxidizing agent, but that surface roughening after the etching becomes a problem.

Accordingly, an object of the present invention is to provide a semiconductor treatment liquid which is capable of suppressing surface roughening after etching and has low toxicity. Another object of the present invention is to provide a method of using the semiconductor treatment liquid as a low-toxicity semiconductor treatment liquid.

### Solution to Problem

The present inventors have conducted intensive studies to produce a low toxic semiconductor treatment liquid. As a result, the present inventors have found that a semiconductor treatment liquid containing a specific quaternary ammonium ion, a halide ion, a hydroxide ion, an oxidizing agent, and water has low toxicity and can suppress surface roughening after etching, and have completed the present invention.

That is, the present invention is configured as follows.

Aspect 1: A semiconductor treatment liquid containing:
(A) a quaternary ammonium ion represented by formula (1) below;
(B) a halide ion;
(C) a hydroxide ion;
(D) an oxidizing agent; and
(E) water, 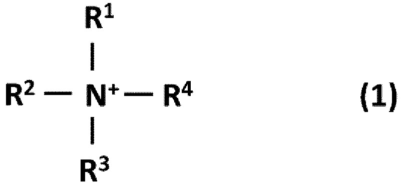
where R¹, R², R³, and R⁴ are each independently an alkyl group having carbon number from 1 to 16, provided that one or more alkyl groups among R¹, R², R³, and R⁴ have carbon number from 2 to 16.

Aspect 2: The semiconductor treatment liquid according to Aspect 1, wherein R¹, R², R³, and R⁴ in the formula (1) are not all the same alkyl group.

Aspect 3: The semiconductor treatment liquid according to Aspect 1 or 2, wherein R¹, R², and R³ in the formula (1) are methyl groups, and R⁴ in the formula (1) is an alkyl group having carbon number from 2 to 16.

Aspect 4: The semiconductor treatment liquid according to any one of Aspects 1 to 3, wherein the halide ion (B) is a chloride ion or a bromide ion.

Aspect 5: The semiconductor treatment liquid according to any one of Aspects 1 to 4, wherein a concentration of the halide ion in the semiconductor treatment liquid is from 0.1 ppm by mass to 5.0 mass%.

Aspect 6: The semiconductor treatment liquid according to any one of Aspects 1 to 5, wherein an LD₅₀ value converted assuming that an amount of hydroxide of the quaternary ammonium ion is 100 mass%, in a toxicity test using a rat based on an acute oral toxicity test in accordance with OECD Test Guideline 420, is more than 50 mg/kg.

Aspect 7: The semiconductor treatment liquid according to any one of Aspects 1 to 6, wherein the oxidizing agent contains at least one halogen oxyacid ion selected from the group consisting of a hypochlorite ion, a hypobromite ion, and a periodate ion.

Aspect 8: The semiconductor treatment liquid according to any one of Aspects 1 to 7, further containing one or more compounds selected from the group consisting of an alcohol and an amine.

Aspect 9: A method of using the semiconductor treatment liquid according to any one of Aspects 1 to 8 as a low-toxicity semiconductor treatment liquid.

### Effects of Invention

According to the present invention, a low-toxicity semiconductor treatment liquid is provided. As a result, there is provided a semiconductor treatment liquid which is highly safe in use and also leads to a low environmental load. There is also provided a method of using the semiconductor treatment liquid as a low-toxicity semiconductor treatment liquid.

### Brief Description of Drawings

The figure is an explanatory view illustrating an electrolytic cell.

### Description of Embodiments

Embodiments of the present invention are described in detail below, but as long as the gist of the present invention is observed, the present invention is not limited to the details described below. In addition, the present invention can be modified and implemented in any manner that does not depart from the gist of the present invention.

In the present specification, a numerical range expressed using the term "to" refers to a range including the numerical values described before and after "to" as the lower limit and the upper limit, respectively. Thus, the expression "A to B" means A or more and B or less. Further, when numerical ranges are described in a stepwise manner, the upper limit and the lower limit of each numerical range can be optionally combined.

The semiconductor treatment liquid according to an embodiment of the present invention contains:
(A) a quaternary ammonium ion represented by formula (1) below;
(B) a halide ion;
(C) a hydroxide ion;
(D) an oxidizing agent; and
(E) water, 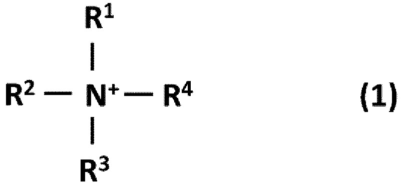
where R¹, R², R³, and R⁴ are each independently an alkyl group having carbon number from 1 to 16 (preferably from 1 to 8, and more preferably from 1 to 4), provided that one or more alkyl groups among R¹, R², R³, and R⁴ have carbon number from 2 to 16 (preferably from 2 to 8, and more preferably from 2 to 4).

The semiconductor treatment liquid contains the quaternary ammonium ion represented by the formula (1), and thus tends to have toxicity lower than that of a semiconductor treatment liquid using tetramethylammonium hydroxide.

In addition, the semiconductor treatment liquid contains the quaternary ammonium ion represented by the formula (1), and thus the etching rate can be improved. In addition, roughening of a metal surface after etching can be suppressed. When the carbon numbers of R¹ to R⁴ exceed the above range, the steric hindrance of the quaternary ammonium ion increases, and the etching rate may decrease. In addition, when the carbon numbers of R¹ to R⁴ exceed the above range, a quaternary ammonium halide described below is difficult to be dissolved, and thus the semiconductor treatment liquid may be difficult to be manufactured.

In the formula (1), it is also preferable that R¹, R², R³, and R⁴ be not all the same alkyl group. In other words, compounds represented by the following (1) to (3) are preferred:
(1) a compound in which any three of R¹, R², R³, and R⁴ are the same alkyl group, and the remaining one is an alkyl group different therefrom;
(2) a compound in which any two of R¹, R², R³, and R⁴ are the same alkyl group, and the remaining two are alkyl groups different therefrom (the remaining two can be the same or different); and
(3) a compound in which all of R¹, R², R³, and R⁴ are different alkyl groups.

In the case of the above (1), examples of the compound can include compounds in which any three of R¹, R², R³, and R⁴ are the same alkyl group having carbon number from 1 to 16, the remaining one is an alkyl group having carbon number from 1 to 16, the first three and the remaining one are different alkyl groups, and either the first three or the remaining one has carbon number from 2 to 16. It is preferable that three of R¹, R², R³, and R⁴ in the formula (1) be the same group and that the remaining one be an alkyl group having carbon number from 2 to 16, which is different from the group. In this case, the compound represented by the formula (1) has two types of alkyl groups. In this aspect, a compound in which any three of R¹, R², R³, and R⁴ are methyl groups and the remaining one alkyl group has carbon number from 2 to 16 is preferred. Among such compounds, a compound in which the remaining one alkyl group has carbon number from 2 to 8 is more preferred, and a compound in which the remaining one alkyl group has carbon number of 2, 3, or 4 is even more preferred.

In the case of the above (2), examples of the compound can include compounds in which any two of R¹, R², R³, and R⁴ are the same alkyl group having carbon number from 1 to 16, the remaining two are alkyl groups having carbon number from 1 to 16, which is different from the first two, the remaining two are the same or different alkyl groups, and either the first two or the remaining two have carbon number from 2 to 16. In this case, the compound represented by the formula (1) has two or three types of alkyl groups.

In the case of the above (3), examples of the compound can include compounds in which all of R¹, R², R³, and R⁴ are different alkyl groups, and at least one of them has carbon number from 2 to 16. In this case, the compound represented by the formula (1) has four types of alkyl groups.

In the formula (1), all of R¹, R², R³, and R⁴ are optionally the same alkyl group. For example, all of R¹, R², R³, and R⁴ are optionally ethyl, propyl, or butyl.

Specific examples of the quaternary ammonium ion represented by the formula (1) include a tetraethylammonium ion, a tetrapropylammonium ion, a tetrabutylammonium ion, an ethyltrimethylammonium ion, a diethyldimethylammonium ion, a triethylmethylammonium ion, a propyltrimethylammonium ion, and a butyltrimethylammonium ion. One of the quaternary ammonium ions can be used, or a plurality thereof can be used.

The semiconductor treatment liquid contains a hydroxide ion. The fact that the semiconductor treatment liquid contains the quaternary ammonium ion represented by the formula (1) and the hydroxide ion can also be said to indicate that the semiconductor treatment liquid contains a quaternary ammonium hydroxide containing the quaternary ammonium ion represented by the formula (1) and the hydroxide ion. The semiconductor treatment liquid contains a quaternary ammonium hydroxide, and thus can be used as a semiconductor treatment liquid.

Concentrations of the quaternary ammonium ion represented by the formula (1) and the hydroxide ion in the semiconductor treatment liquid are not particularly limited, and a semiconductor treatment liquid containing a quaternary ammonium hydroxide at a concentration of from 1.00 to 65.00 mass% is preferably manufactured. For example, the quaternary ammonium hydroxide is more preferably used at a concentration of from 1.00 to 5.00 mass%, and is even more preferably used at a concentration of from 1.50 to 3.50 mass%. The concentration is also preferably from 15.00 to 35.00 mass%, and more preferably from 20.00 to 30.00 mass%.

The quaternary ammonium hydroxide is preferably used at a molarity of from 0.10 to 0.50 mol/L, and is more preferably used at a molarity of from 0.15 to 0.35 mol/L.

The concentration of the quaternary ammonium ion represented by the formula (1) in the semiconductor treatment liquid is preferably from 0.01 to 20.00 mass%. In addition, the concentration is more preferably from 0.01 to 10.00 mass%, and even more preferably from 0.05 to 5.00 mass%.

The concentration of the hydroxide ion in the semiconductor treatment liquid is preferably from 0.001 ppm by mass to 2.00 mass%. In addition, the concentration is more preferably from 0.01 ppm by mass to 0.20 mass%, and even more preferably from 0.1 ppm by mass to 0.20 mass%.

The semiconductor treatment liquid contains an oxidizing agent. The semiconductor treatment liquid contains an oxidizing agent, and thus can be imparted with an etching function. The type of oxidizing agent is not particularly limited, but examples include one or more selected from the group consisting of hydrogen peroxide, ozone, hypochlorous acid, chlorous acid, chloric acid, perchloric acid, hypobromous acid, bromous acid, bromic acid, perbromic acid, hypoiodous acid, iodous acid, iodic acid, periodic acid, their salts, and ions produced by dissociation of these salts; and furthermore, hydrogen peroxide, ozone, fluorine, chlorine, bromine, iodine, permanganates, chromates, dichromates, and cerium salts. For example, the oxidizing agent can contain at least one halogen oxyacid ion selected from the group consisting of a hypochlorite ion, a hypobromite ion, and a periodate ion. The type of preferred oxidizing agent varies depending on the transition metal to be etched. For example, hydrogen peroxide, hypochlorous acid and hypochlorite ion, hypobromous acid and hypobromite ion, and periodic acid and periodate ion are suitably used for Si, W and Mo, hydrogen peroxide is preferably used for Ti-based metals, and hypochlorite ion, hypobromite ion, periodate ion and permanganate ion are suitably used for Ru-based metals.

One or plurality of oxidizing agents can be contained in the semiconductor treatment liquid. When a plurality of oxidizing agents are contained, the etching rate may be stabilized, and the stability when the semiconductor treatment liquid is reused may be improved. For example, in a case where a hypobromite ion is contained as a first oxidizing agent, a hypobromite ion consumed in etching a metal loses its oxidizing power and changes into a bromide ion. In this case, the larger the amount of the hypobromite ion having changed into a bromide ion, the more the etching ability decreases. In a semiconductor wafer manufacturing plant, a treatment liquid is commonly recycled and reused from the viewpoint of cost reduction. However, decrease in etching ability due to the reuse of the treatment liquid would make it difficult to stably manufacture semiconductor wafers. In contrast, in a case where the semiconductor treatment liquid contains a plurality of oxidizing agents, for example, when a hypochlorite ion is contained in addition to a hypobromite ion, a bromide ion losing its oxidizing power is oxidized with the hypochlorite ion and changes into a hypobromite ion. This makes it possible to suppress the decrease in the hypobromite ion concentration in the semiconductor treatment liquid, and the etching rate is less likely to decrease even in a case of reusing the semiconductor treatment liquid.

### (Countercation of Oxidizing Agent)

A countercation of the oxidizing agent contained in the semiconductor treatment liquid according to an embodiment of the present invention is not particularly limited, and is preferably a metal ion or an onium ion described below. As the metal ion, an alkali metal ion such as sodium, potassium or calcium, or an alkaline earth metal ion such as magnesium or calcium can be used. As the onium ion, for example, a quaternary ammonium ion represented by the formula (1) can be used. In semiconductor manufacturing, when a metal or a metal ion remains on a semiconductor wafer, there is a possibility that abnormality occurs in electrical characteristics or a processed shape. Therefore, it is desirable that neither metal nor metal ion be contained as possible, and as the countercation of the oxidizing agent, an onium ion is preferred.

### (Hydrogen Peroxide)

The hydrogen peroxide that can be contained in the semiconductor treatment liquid according to an embodiment of the present invention can be produced by adding a commercially available aqueous hydrogen peroxide solution to the semiconductor treatment liquid.

The content of the hydrogen peroxide in the semiconductor treatment liquid is not particularly limited, but is preferably 0.001 mol/L or more and 6.0 mol/L or less, and more preferably 0.01 mol/L or more and 3.0 mol/L or less.

When the content of the hydrogen peroxide is within the above range, it is possible to stably etch the transition metal at a sufficient rate. When the content is less than 0.001 mol/L, the rate of etching the transition metal is low, resulting in low practicality. In contrast, when the content is higher than 6.0 mol/L, the hydrogen peroxide is easily decomposed, and thus the transition metal is less likely to be stably etched.

The content of the hydrogen peroxide in the semiconductor treatment liquid can be determined using a widely known method. For example, the hydrogen peroxide concentration can be determined by adding sulfuric acid to a semiconductor treatment liquid containing hydrogen peroxide, and performing redox titration using a potassium permanganate solution under sulfuric acid acidity.

### (Hypochlorite Ion)

The hypochlorous acid and hypochlorite ion which can be contained in the semiconductor treatment liquid according to an embodiment of the present invention can be generated in the treatment liquid or can be added as a hypochlorite salt to the treatment liquid. The hypochlorite salt referred to here is a salt containing the hypochlorite ion or a solution containing the salt containing the hypochlorite ion. To generate hypochlorite ions in the treatment liquid, for example, chlorine gas is blown into the treatment liquid. In this case, from the viewpoint of efficiently producing hypochlorite ions, the treatment liquid is preferably at a temperature of 50°C or lower. When the treatment liquid is at 50°C or lower, not only hypochlorite ions can be generated efficiently but also the generated hypochlorite ions can be stably used in the treatment liquid.

Furthermore, to dissolve more chlorine in the treatment liquid, the temperature of the treatment liquid is more preferably 30°C or lower and most preferably 25°C or lower. The lower limit of the temperature of the treatment liquid is not particularly limited, but the treatment liquid preferably does not freeze. Thus, the treatment liquid is preferably at -35°C or higher, more preferably at -15°C or higher, and most preferably at 0°C or higher. The pH of the treatment liquid into which the chlorine gas is blown is not particularly limited, but when the pH of the treatment liquid is alkaline, the treatment liquid is available for semiconductor treatment immediately after the generation of the hypochlorite ions.

Furthermore, in a case where hypochlorite ions are generated by blowing chlorine gas into the treatment liquid, when the treatment liquid contains chloride ions (Cl⁻), the solubility of chlorine gas (Cl₂) is improved. This is because Cl₂ dissolved in the treatment liquid reacts with Cl⁻ and Cl₃⁻ to form a complex ion, such as Cl₃⁻ or Cl₅⁻, which is stabilized in the treatment liquid. The treatment liquid containing a large amount of Cl₂, Cl⁻, Cl₃⁻, or Cl₅⁻ can generate more hypochlorite ions and thus can be suitably used as the treatment liquid according to an embodiment of the present invention.

It is also possible to produce hypochlorite ions in the treatment liquid by oxidizing a chlorine-containing compound with an oxidizing agent.

To add hypochlorite ions as a compound to the treatment liquid, hypochlorous acid, chlorine water, and/or a hypochlorite salt only has to be added. As the hypochlorite salt, sodium hypochlorite, potassium hypochlorite, or a tetraalkylammonium hypochlorite are suitably used. From the viewpoint of absence of a metal ion, which is otherwise problematic in semiconductor production, hypochlorous acid or a tetraalkylammonium hypochlorite is more suitable.

The tetraalkylammonium hypochlorite is easily produced by causing chlorine gas to pass through a tetraalkylammonium hydroxide solution. In addition, the tetraalkylammonium hypochlorite is also produced by mixing hypochlorous acid and a tetraalkylammonium hydroxide solution. Furthermore, the tetraalkylammonium hypochlorite can also be produced by substituting a cation contained in a hypochlorite salt, such as sodium hypochlorite, with a tetraalkylammonium ion using an ion exchange resin.

The concentration of the hypochlorite ion in the semiconductor treatment liquid according to an embodiment of the present invention is not particularly limited as long as the semiconductor treatment liquid does not depart from the object of the present invention, but the concentration is preferably 0.001 mol/L or more and 1.5 mol/L or less. When the concentration is less than 0.001 mol/L, the rate of etching the transition metal is low, resulting in low practicality. In contrast, when the concentration is higher than 1.5 mol/L, the hypochlorite ion would be easily decomposed, and thus the rate of etching the transition metal is less likely to be stable. For stable etching of the transition metal at a sufficient rate, the concentration of the hypochlorite ion is preferably 0.001 mol/L or more and 1.5 mol/L or less, more preferably 0.005 mol/L or more and 1.0 mol/L or less, and most preferably 0.01 mol/L or more and 0.40 mol/L or less in terms of chlorine element contained in the hypochlorite ion.

The concentration of the hypochlorite ion in the semiconductor treatment liquid can be determined using a widely known method. For example, using ultraviolet-visible absorption spectroscopy, absorption due to hypochlorite ions can be easily observed and the hypochlorite ion concentration can be determined from the intensity of the absorption peak (generally at or near 292 nm although this depends on the pH of the treatment liquid and the hypochlorite ion concentration). Furthermore, the hypochlorite ion concentration can also be determined by iodometry. In addition, the hypochlorite ion concentration can be determined from the oxidation-reduction potential (ORP) of the treatment liquid. The measurement by ultraviolet-visible absorption spectroscopy is most preferred from the viewpoint of enabling contactless and continuous measurement. Note that in measuring the hypochlorite ion concentration by ultraviolet-visible absorption spectroscopy, in a case where absorption due to another chemical species is present, the hypochlorite ion concentration can be determined with sufficient accuracy by data processing, such as spectral splitting or baseline correction, properly selecting the reference, or the like.

### (Hypobromite Ion)

The hypobromite ion which can be contained in the treatment liquid according to an embodiment of the present invention can be generated in the semiconductor treatment liquid or can be added as a hypobromite salt to the semiconductor treatment liquid. The hypobromite salt referred to here is a salt containing the hypobromite ion or a solution containing the salt containing the hypobromite ion. To generate hypobromite ions (BrO⁻, also described as BrO) in the semiconductor treatment liquid, for example, bromine gas only has to be blown into the semiconductor treatment liquid. In this case, from the viewpoint of efficiently producing hypobromite ions, the semiconductor treatment liquid is preferably at a temperature of 20°C or higher and 50°C or lower. When the semiconductor treatment liquid is at 50°C or lower, not only hypobromite ions can be generated efficiently but also the generated hypobromite ions can be stably used in the semiconductor treatment. Furthermore, to dissolve more bromine in the semiconductor treatment liquid, the temperature of the semiconductor treatment liquid is more preferably 20°C or higher and most preferably 30°C or higher. The pH of the semiconductor treatment liquid into which the bromine gas is blown is not particularly limited, but when the pH of the treatment liquid is alkaline, the semiconductor treatment liquid is available for semiconductor treatment immediately after the generation of the hypobromite ions.

Furthermore, in a case where hypobromite ions are generated by blowing bromine gas into the semiconductor treatment liquid, when the semiconductor treatment liquid contains bromide ions (Br⁻), the solubility of bromine gas (Br₂) improves. This is because Br₂ dissolved in the semiconductor treatment liquid reacts with Br⁻ and Br₃⁻ and forms a complex ion, such as Br₃⁻or Br₅⁻, which is stabilized in the semiconductor treatment liquid. The semiconductor treatment liquid containing a large amount of Br₂, Br⁻, Br₃⁻, or Br₅⁻ can form more hypobromite ions and thus can be suitably used as the semiconductor treatment liquid according to an embodiment of the present invention.

It is also possible to produce hypobromite ions in the semiconductor treatment liquid by oxidizing a bromine-containing compound with an oxidizing agent. As an example, hypochlorite ions as an oxidizing agent and tetramethylammonium bromide as a bromine-containing compound are mixed, and thus the hypochlorite ions oxidize bromide ions to produce hypobromite ions.

To add hypobromite ions as a compound to the semiconductor treatment liquid, hypobromous acid, bromine water, and/or a hypobromite salt only has/have to be added. As the hypobromite salt, sodium hypobromite, potassium hypobromite, or a tetraalkylammonium hypobromite are suitably used. From the viewpoint of absence of a metal ion, which is otherwise problematic in semiconductor manufacturing, hypobromous acid or a tetraalkylammonium hypobromite is more suitable.

The tetraalkylammonium hypobromite described above is easily produced by causing bromine gas to pass through a tetraalkylammonium hydroxide solution. In addition, the tetraalkylammonium hypobromite is also produced by mixing hypobromous acid and a tetraalkylammonium hydroxide solution. Furthermore, the tetraalkylammonium hypobromite can also be produced by substituting a cation contained in a hypobromite salt, such as sodium hypobromite, with a tetraalkylammonium ion using an ion exchange resin.

The content of the hypobromite ion in the semiconductor treatment liquid is not particularly limited, but is preferably 0.001 mol/L or more and 0.50 mol/L or less, and more preferably 0.001 mol/L or more and 0.20 mol/L or less.

When the content of the hypobromite ion is within the above range, it is possible to stably etch the transition metal at a sufficient rate. When the content is less than 0.001 mol/L, the rate of etching the transition metal is low, resulting in low practicality. In contrast, when the concentration is higher than 0.50 mol/L, a hypobromite ion is easily decomposed, and thus the transition metal is less likely to be stably etched. The content of the hypobromite ion in the semiconductor treatment liquid can be determined using a widely known method. For example, using ultraviolet-visible absorption spectroscopy, absorption due to hypobromite ions can be easily observed and the hypobromite ion concentration can be determined from the intensity of the absorption peak (generally at or near 330 nm although this depends on the pH of the residue removing liquid and the hypobromite ion concentration). Furthermore, the hypobromite ion concentration can also be determined by iodometry. In addition, the hypobromite ion concentration can be determined from the oxidation-reduction potential (ORP) of the residue removing liquid. The measurement by ultraviolet-visible absorption spectroscopy is most preferred from the viewpoint of enabling contactless and continuous measurement. In measuring the hypobromite ion concentration by ultraviolet-visible absorption spectroscopy, when absorption due to another chemical species is present, the hypobromite ion concentration can be measured with sufficient accuracy by data processing, such as spectral splitting or baseline correction, properly selecting the reference, or the like.

### (Periodic Acid Compound)

Examples of a periodic acid compound that can be contained in the semiconductor treatment liquid according to an embodiment of the present invention include orthoperiodic acid, metaperiodic acid, and ions thereof. The treatment liquid according to an embodiment of the present invention containing these periodic acids can be produced by adding commercially available periodic acids to the semiconductor treatment liquid.

The content of the periodic acid compound in the semiconductor treatment liquid is not particularly limited, but is preferably 0.001 mol/L or more and 1.0 mol/L or less, and more preferably 0.01 mol/L or more and 0.5 mol/L or less.

When the content of the periodic acid compound is within the above range, it is possible to stabilize and etch the transition metal at a sufficient rate. When the content is less than 0.001 mol/L, the rate of etching the transition metal is low, resulting in low practicality. In contrast, with the concentration more than 1.0 mol/L, the transition metal is less likely to be stably etched.

The content of the periodic acid compound in the semiconductor treatment liquid can be determined using a widely known method. For example, the periodic acid concentration can be determined by adding sulfuric acid to a semiconductor treatment liquid containing a periodic acid compound, and performing iodometry under sulfuric acid acidity.

The halide ion is not particularly limited, and specific examples thereof include one or more selected from the group consisting of a chloride ion, a bromide ion, and an iodide ion. In addition, a chloride ion or a bromide ion is preferred. When the semiconductor treatment liquid contains halide ions, roughening of the metal surface after etching can be suppressed. Since it is presumed that halogen would be present somewhat uniformly even on the metal surface in the treatment liquid, it is presumed that the rate of etching the metal by the oxidizing agent can be controlled to some extent. It is presumed that the surface roughening due to etching can be suppressed by making the rate of etching the metal uniform.

The concentration of the halide ion in the semiconductor treatment liquid is not particularly limited, but is preferably from 0.01 ppm by mass to 20.0 mass%, more preferably from 0.1 ppm by mass to 10.0 mass%, and even more preferably from 0.1 ppm by mass to 5.0 mass%. When the semiconductor treatment liquid contains a large amount of halide ions, the halide ions may remain on the surface of the semiconductor. In such a case, the properties of the semiconductor may deteriorate. When the concentration of the halide ion in the semiconductor treatment liquid is less than 0.01 ppm by mass, surface roughening due to non-uniform etching may occur.

When the concentration of the halide ion is within the above range, the properties of the semiconductor produced by using the semiconductor treatment liquid are easily improved.

The concentration of the halide ion in the semiconductor treatment liquid can be analyzed by ion chromatography, and analysis by a neutralization method is particularly effective when the aqueous alkaline solution has a high concentration. Specifically, before the semiconductor treatment liquid is introduced into the anion ion chromatography, cations in the treatment liquid are exchanged with hydrogen ions to convert hydroxide ions into water. Thus, the hydroxide ions can be removed. Further, the sensitivity is enhanced by concentration. By using this method, it is possible to measure the concentration of a low-concentration halide ion. The details will be described later.

The semiconductor treatment liquid contains water. A form of water is not particularly limited. Known water can optionally be used, and it is particularly preferable that the water be ultrapure water in which metal impurities are decreased. The content of water in the semiconductor treatment liquid is not particularly limited, but is preferably 10.00 mass% or more, more preferably 20.00 mass% or more, and even more preferably 30.00 mass% or more. Further, the content is preferably 99.99 mass% or less, and more preferably 99.90 mass% or less. For example, the content is preferably from 10.00 to 99.99 mass%, more preferably from 20.00 to 99.99 mass%, and even more preferably from 30.00 to 99.90 mass%.

The semiconductor treatment liquid can contain one or more compounds selected from the group consisting of an alcohol and an amine. When the compound is contained, wettability of a transition metal surface is improved, and surface roughening caused by non-uniform etching is easily suppressed.

A concentration of the one or more compounds selected from the group consisting of an alcohol and an amine in the semiconductor treatment liquid is not particularly limited, but is preferably from 0.1 ppb by mass to 1.0 mass%, and more preferably from 1 ppb by mass to 0.1 mass%.

The alcohol is not particularly limited, and a known alcohol can be used. Examples of the alcohol include primary alcohols such as methanol, ethanol, and 1-propanol, secondary alcohols such as 2-propanol and 2-butanol, and tertiary alcohols such as 2-methyl-2-propanol. Number of hydroxyl groups of the alcohol is not particularly limited, and a monohydric alcohol can be used, or an alcohol having two or more hydroxyl groups can be used. Among them, a primary alcohol is preferred from the viewpoint of low cost and easy availability. In addition, an alcohol having carbon number of 16 or less (more preferably carbon number from 2 to 8, and even more preferably carbon number from 2 to 4) is preferred from the viewpoint of increasing the possibility of causing adsorption inhibition or the like during semiconductor treatment when the alcohol has a long chain.

The amine is not particularly limited, and a known amine can be used. Examples of the amine include primary amines such as methylamine, secondary amines such as dimethylamine, and tertiary amines such as trimethylamine. Number of amino groups of the amine is not particularly limited, and an amine having one amino groups can be used, or an amine having two or more amino groups can be used. Among them, a tertiary amine is preferred from the viewpoint of low cost and easy availability. In addition, an amine having carbon number of 16 or less (more preferably carbon number from 2 to 8, and even more preferably carbon number from 2 to 4) is preferred from the viewpoint that the amine having a long chain increases the possibility of causing adsorption inhibition or the like during semiconductor treatment.

As evaluation of the toxicity of an aqueous quaternary ammonium hydroxide solution, a median lethal dose (LD₅₀) value converted assuming that an amount of hydroxide of a quaternary ammonium ion is 100 mass%, in a toxicity test using a rat based on an acute oral toxicity test in accordance with OECD Test Guideline 420, is preferably more than 50 mg/kg. As a result, it is safer to use and the environmental load is further reduced. In addition, in the GHS classification, when the LD₅₀ value is 50 mg/kg or less, it falls under Classification 2, and regulations in storage, transportation, and the like are strict, and when the LD₅₀ value is 5 mg/kg or less, it falls under Classification 1, and the regulations are further strict. Therefore, the LD₅₀ value is preferably more than 50 mg/kg. The LD₅₀ value is more preferably more than 100 mg/kg, even more preferably more than 200 mg/kg, and particularly preferably more than 300 mg/kg. The LD₅₀ value can be preferably more than 50 mg/kg and 1000 mg/kg or less, more preferably more than 100 mg/kg and 1000 mg/kg or less, even more preferably more than 200 mg/kg and 1000 mg/kg or less, and most preferably more than 300 mg/kg and 1000 mg/kg or less.

The LD₅₀ value can be adjusted by changing the type of the quaternary ammonium ion represented by the formula (1).

From the viewpoint of this toxicity, for example, it is preferable to use, a quaternary ammonium ion in which R¹, R² and R³ in the formula (1) are alkyl groups having carbon number of 1, and R⁴ is an alkyl group having carbon number from 2 to 4, a quaternary ammonium ion in which R¹, R², R³ and R⁴ are alkyl groups having carbon number of 2, a quaternary ammonium ion in which R¹, R², R³ and R⁴ are alkyl groups having carbon number of 3, and a quaternary ammonium ion in which R¹, R², R³ and R⁴ are alkyl groups having carbon number of 4. More specifically, an ethyltrimethylammonium ion, a propyltrimethylammonium ion, a butyltrimethylammonium ion, a tetraethylammonium ion, a tetrapropylammonium ion, and a tetrabutylammonium ion are preferred.

The semiconductor treatment liquid can be used as, for example, an etching liquid. Further, it can be used, for example, as a treatment liquid for a semiconductor with a transition metal. The transition metal in an embodiment of the present invention includes, for example, one or more metals selected from the group consisting of Si, Ru, Rh, Ti, Ta, Co, Cr, Hf, Os, Pt, Ni, Mn, Cu, Zr, La, Mo, and W. In addition, the transition metal can include an oxide, a nitride, an oxynitride, a carbide, and a silicide of these transition metals.

Furthermore, the semiconductor treatment liquid can be used as a low-toxicity semiconductor treatment liquid. That is, one aspect of the present invention is a method of using the semiconductor treatment liquid of the present invention as a low-toxicity semiconductor treatment liquid.

A method for manufacturing the semiconductor treatment liquid according to an embodiment of the present invention is not particularly limited, and can include, for example, a preparation step A of preparing an aqueous alkaline solution for a semiconductor as a raw material; a mixing step of mixing the aqueous alkaline solution for a semiconductor, an oxidizing agent and, if necessary, water to a predetermined concentration to produce a mixture; and a dissolution step of uniformly dissolving the resulting mixture. These steps can be combined into one step.

The preparation step A of preparing an aqueous alkaline solution for a semiconductor is not particularly limited, but from the viewpoint of suppressing the halide ion concentration, it is preferable to produce an aqueous alkaline solution for a semiconductor by electrolyzing an aqueous quaternary ammonium halide solution. That is, the preparation step A preferably includes an electrolysis step of electrolyzing the aqueous quaternary ammonium halide solution. Specifically, the preparation step A preferably includes an electrolysis step of electrolyzing an aqueous quaternary ammonium halide solution containing the following (A), (B), and (E). (A), (B), and (E) as described above can be used:
(A) a quaternary ammonium ion represented by formula (1) below;
(B) a halide ion; and
(E) water, 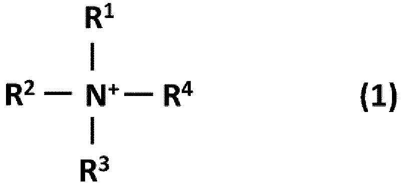
where R¹, R², R³, and R⁴ are each independently an alkyl group having carbon number from 1 to 16 (preferably from 1 to 8, and more preferably from 1 to 4), provided that one or more alkyl groups among R¹, R², R³, and R⁴ have carbon number from 2 to 16 (preferably from 2 to 8, and more preferably from 2 to 4).

The manufacturing of the aqueous alkaline solution for a semiconductor by electrolysis can be performed by using an electrolytic cell in which one or more cation exchange membranes are disposed between an anode and a cathode and which is provided with a raw material chamber for supplying an aqueous quaternary ammonium halide solution as a raw material and a base chamber (cathode chamber) in which an aqueous quaternary ammonium hydroxide solution is produced. In the manufacturing method using this electrolytic cell, quaternary ammonium ions contained in the aqueous quaternary ammonium halide solution pass through the cation exchange membrane disposed on the cathode side during electrolysis. As a result, an aqueous quaternary ammonium hydroxide solution is produced in the base chamber.

The above example is an example in which one or more cation exchange membranes are disposed. However, an electrolytic cell in which a plurality of membranes selected from the group consisting of a cation exchange membrane, an anion exchange membrane, and a bipolar membrane (a composite membrane composed of a cation exchange membrane and an anion exchange membrane) are disposed can be used as long as an aqueous quaternary ammonium hydroxide solution can be produced.

At this time, a halide ion which is an anion of the quaternary ammonium halide moves to the anode side, but a part of the halide ion also moves to the cathode side by diffusion. Therefore, depending on the concentration of the liquid used as the raw material, about from 1 to several tens ppm of halide ions may be mixed into the aqueous quaternary ammonium hydroxide solution.

The method for manufacturing a semiconductor treatment liquid can include, before the electrolysis step, a preparation step B of preparing an aqueous quaternary ammonium halide solution to be used as a raw material in the electrolysis step.

The preparation step B is not particularly limited. For example, an aqueous quaternary ammonium halide solution can be prepared by manufacturing an aqueous quaternary ammonium halide solution. A method for manufacturing the aqueous quaternary ammonium halide solution is not particularly limited. For example, from the viewpoint of productivity and quality, it is preferably a step of producing a quaternary ammonium halide by reacting a trialkylamine with an alkyl halide in ultrapure water.

The trialkylamine and alkyl halide used as raw materials are not particularly limited as long as the quaternary ammonium ion represented by the formula (1) can be produced. Specifically, among the alkyl groups contained in the trialkylamine and the alkyl groups contained in the alkyl halide, one or more alkyl groups are alkyl groups having carbon number from 2 to 16 (preferably from 2 to 8, and more preferably from 2 to 4), and the other alkyl groups are alkyl groups having carbon number from 1 to 16 (preferably from 1 to 8, and more preferably from 1 to 4).

The halide ion which is an anion of an alkyl halide can be the same as (B) described above.

Since impurities contained in the quaternary ammonium halide are also diffused and mixed into the aqueous quaternary ammonium hydroxide solution, it is preferable to use a highly pure quaternary ammonium halide. Specifically, a concentration of any one of metals selected from the group consisting of lithium, sodium, potassium, aluminum, magnesium, calcium, chromium, manganese, iron, nickel, cobalt, cupper, silver, cadmium, barium, zinc and lead in the aqueous quaternary ammonium halide solutions is preferably from 0.01 ppt to 1 ppb on a mass basis.

### Examples

The present invention will be more specifically described below by way of Examples, but is not limited to these Examples. The evaluations performed in Examples and Comparative Examples were determined by the following methods.

### [Evaluation Method]

### 1) Halide Ion Concentration

The measurement of the halide ion concentration in the semiconductor treatment liquid was analyzed using an ion chromatography analyzer (DIONEX INTEGRION HPLC, available from Thermo SCIENTIFIC). An aqueous KOH solution was used as the eluent and was fed at a flow rate of 1.2 mL/min. An anion analysis column for a hydroxide-based eluent (AS15, available from Thermo SCIENTIFIC) was used as the column, and the column temperature was set to 30°C. Background noise was removed using a suppressor, after which the halide ions in the treatment liquid were quantified by an electrical conductivity detector.

### 2) Hydroxide Ion Concentration

The aqueous solutions (1 mL) prepared in Examples and Comparative Examples were subjected to neutralization titration with 0.1 mol/L hydrochloric acid using a Hiranuma automatic titrator (COM-1700, available from HIRANUMA). The hydroxide ion concentration was determined from the liquid amount of 0.1 mol/L hydrochloric acid required for neutralization.

### 3) Etching Test

For each of Examples, 60 mL of the treatment liquid was prepared in a fluororesin container with a lid (94.0-mL PFA container, available from As One Corporation). Each semiconductor wafer piece for evaluation having a size of 10 × 20 mm was immersed in the treatment liquid at 25°C or 50°C for 1 minute. A value yielded by dividing the amount of change in film thickness before and after the treatment by the immersion time was calculated as an etching rate. The etching rate was evaluated according to the following criteria. In any example, evaluations A to C are acceptable levels, and an evaluation D is an unacceptable level.

### (Titanium Nitride Film, Ruthenium Film, Molybdenum Film)

A: > 50 Å/min
B: from 50 to 20 Å/min
C: from 20 to 10 Å/min (acceptable level)
D: failed to etch

### (Tungsten Film)

A: > 500 Å/min
B: from 500 to 100 Å/min
C: from 100 to 10 Å/min (acceptable level)
D: failed to etch

### 4) Surface Evaluation after Etching

The metal surface before and after etching was observed with a field emission scanning electron microscope (JSM-7800F Prime, available from JEOL Ltd.), the presence or absence of roughening of the surface was observed and evaluated by the following criteria. Surface roughening was evaluated as A to D in the order of less to more roughening, and in any example, evaluations A to C are acceptable levels, and an evaluation D is an unacceptable level.
A: no roughening of surface is observed
B: slight roughening of surface is observed
C: roughening is observed on the entire surface, but the roughness is shallow
D: roughening is observed on the entire surface, and the roughness is deep

### 5) Toxicity Test

Data was collected for median lethal dose (LD₅₀) in a toxicity test using a rat. A toxicity test based on an acute oral toxicity test in accordance with OECD Test Guideline 420 was carried out for those without data disclosed.

The resulting median lethal dose was converted assuming that the amount of the aqueous quaternary ammonium hydroxide solution is 100 mass%, and evaluated based on the following criteria. When two or more aqueous quaternary ammonium hydroxide solutions were mixed, the median lethal dose of each aqueous quaternary ammonium hydroxide solution was multiplied by the mixing rate, and the sum of the resulting values was calculated. The results are depicted in Table 1.
A: the median lethal dose is more than 2000 mg/kg
B: the median lethal dose is more than 300 mg/kg and 2000 mg/kg or less
C: the median lethal dose is more than 50 mg/kg and 300 mg/kg or less
D: the median lethal dose is 50 mg/kg or less

Evaluations A to C indicate that the treatment liquid is a low-toxicity semiconductor treatment liquid, and evaluations A to B are preferred.

### (Reagent)

The reagents used in Examples and Comparative Examples were as follows.
- Hydrogen peroxide (H₂O₂): available from FUJIFILM Wako Pure Chemical Corporation
- Orthoperiodic acid (H₅IO₆): available from FUJIFILM Wako Pure Chemical Corporation
- Metaperiodic acid (HIO₄): available from Sigma-Aldrich Co. LLC.
- Hydrochloric acid (HCl): available from Kanto Chemical Co., Inc.
- Hydrobromic acid (HBr): available from Tama Chemicals Co., Ltd.
- Hydriodic acid (HI): available from Tokyo Chemical Industry Co., Ltd.
- Ethyltrimethylammonium hydroxide (ETMAH, made from raw materials)
- Propyltrimethylammonium hydroxide (PTMAH, made from raw materials)
- Butyltrimethylammonium hydroxide (BTMAH, made from raw materials)
- Tetrapropylammonium hydroxide (TPAH, available from Tokyo Chemical Industry Co., Ltd.)
- Tetrabutylammonium hydroxide (TBAH, available from Tokyo Chemical Industry Co., Ltd.)
- Tetramethylammonium hydroxide (TMAH, manufactured by Tokuyama Corporation)

The concentrations of TPAH, TBAH and TMAH were prepared as shown in Table 1.

### (Preparation of Aqueous Quaternary Ammonium Hydroxide Solution)

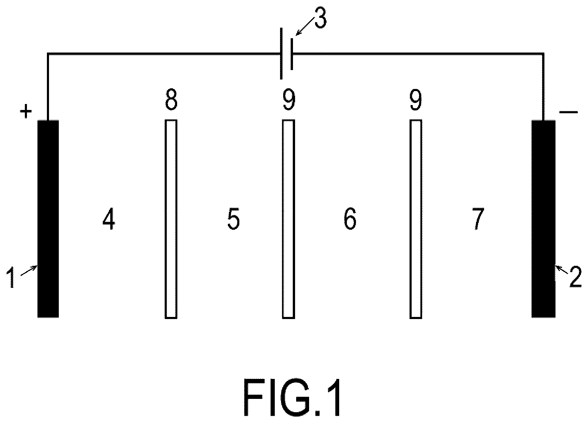

ETMAH (ethyltrimethylammonium hydroxide), PTMAH (propyltrimethylammonium hydroxide), and BTMAH (butyltrimethylammonium hydroxide) were produced according to the following procedure. An aqueous quaternary ammonium halide solution was produced from trialkylamine and alkyl halide as raw materials, and an aqueous quaternary ammonium hydroxide solution was produced by electrolysis using the aqueous quaternary ammonium halide solution as a raw material. Specifically, in the case of ETMAH, trimethylamine and ethyl chloride at a molar ratio of 1:1 were put into a reaction vessel containing ultrapure water, which were retained at a reaction temperature of 60°C to produce a 50 mass% aqueous ethyltrimethylammonium chloride solution. Trimethylamine and ethyl chloride, which were unreacted components, and ethanol, which was a by-product, were each removed under reduced pressure until the amounts thereof were each less than 100 ppm, and then ETMAH was produced using the electrolytic cell shown in FIG. 1. In FIG. 1, 1 denotes an anode, 2 denotes a cathode, 3 denotes a power supply, 4 denotes an anode chamber, 5 denotes a raw material chamber, 6 denotes an intermediate chamber, 7 denotes a cathode chamber, 8 denotes an anion exchange membrane, and 9 denotes a cation exchange membrane.

A platinum-plated nickel plate was used as the cathode, a platinum-plated titanium plate was used as the anode, Nafion N324 (available from The Chemours Company) was used as the cation exchange membrane, and ASE (available from ASTOM CORPORATION) was used as the anion exchange membrane. Electrolysis was continuously carried out while gradually increasing the current density and finally maintaining the current density at 30 A/dm² and the temperature at 40°C, by circulating 0.5 N hydrochloric acid in the anode chamber, a 50 mass% aqueous ethyltrimethylammonium chloride solution in the raw material chamber between the anion exchange membrane and the cathode-side cation exchange membrane, and ultrapure water in the intermediate chamber between the cathode chamber and the two cation exchange membranes. During the electrolysis, the aqueous ethyltrimethylammonium chloride solution was replenished, and the concentration of ethyltrimethylammonium chloride in the raw material chamber was maintained at 40 mass% or more. When the concentration of ETMAH in the cathode chamber increased to 30 mass%, the electrolysis was terminated, resulting in the formation of an aqueous ETMAH solution.

PTMAH and BTMAH were produced in the same manner as in the production of ETMAH except that propyl chloride and butyl chloride were used as alkyl halides, respectively.

### <Examples 1 to 5 and Comparative Examples 1 and 5>

### (Preparation of Semiconductor Treatment Liquid Containing Hydrogen Peroxide)

Ion-exchanged water, hydrogen peroxide, and hydrochloric acid were added to the aqueous quaternary ammonium hydroxide solution produced by the above operation to prepare a treatment liquid having the composition as shown in Table 1. In Example 4, however, the aqueous TBAH solution prepared in the section " Reagents " was used instead of the aqueous quaternary ammonium hydroxide solution produced by the above operation. Also in Example 5, the aqueous TPAH solution prepared in the section "Reagent" was used instead of the aqueous quaternary ammonium hydroxide solution produced by the above operation. Further, also in Comparative Examples 1 and 5, the TMAH aqueous solution prepared in the section "Reagent" was used instead of the aqueous quaternary ammonium hydroxide solution produced by the above operation.

The concentrations of the amines in the semiconductor treatment liquids were all less than 100 ppm by mass. Further, the concentrations of the alcohols in the semiconductor treatment liquids were all less than 100 ppm by mass.

### <Examples 6 to 10 and Comparative Example 2>

### (Preparation of Semiconductor Treatment Liquid Containing Hypochlorite Ion)

In a 2 L glass three-neck flask (available from Cosmos Bead Co., Ltd.), the aqueous quaternary ammonium hydroxide solution produced by the above operation and ion-exchanged water were mixed to produce a 1.69 mol/L aqueous quaternary ammonium hydroxide solution. The pH at this time was 14.2.

Next, a rotor (available from As One Corporation, full length 30 mm × diameter 8 mm) was inserted into the three-neck flask, and a thermometer protection tube (available from Cosmos Bead Co., Ltd., Bottom Sealed Type) and a thermometer were inserted into one opening of the flask. Further, a PFA tube (available from Flon Industry Co., Ltd., F-8011-02) connected to a chlorine gas cylinder and a nitrogen gas cylinder and capable of switching between chlorine gas and nitrogen gas in a freely-selective manner was connected to another opening of the flask, and the tip end of the PFA tube was immersed in the bottom portion of the aqueous solution. Additionally, the remaining one opening was connected to a gas washing bottle (available from As One Corporation, gas washing bottle, model number 2450/500) filled with a 5 wt.% aqueous sodium hydroxide solution. Nitrogen gas was then introduced through the PFA tube at 200 ccm (25°C) for 20 minutes, and carbon dioxide in the gas phase section was purged.

Subsequently, a magnetic stirrer (C-MAG HS1 0, available from As One Corporation) was placed in the bottom portion of the three-neck flask, and while the magnetic stirrer was rotated at 300 rpm and the periphery of the three-neck flask was cooled with ice water, chlorine gas (available from Fujiox Co., Ltd., specification purity of 99.4%) was supplied at 200 ccm (25°C) for 360 minutes, resulting in the formation of a 1.5 mol/L aqueous quaternary ammonium hypochlorite solution (containing 1.5 mol/L quaternary ammonium chloride and 0.05 mol/L quaternary ammonium hydroxide). At this time, the solution temperature during the reaction was 11°C.

Hydrochloric acid and an aqueous quaternary ammonium solution were added to the resulting aqueous quaternary ammonium hypochlorite solution to prepare a treatment liquid having the composition as shown in Table 1.

In Comparative Example 2, however, the aqueous TMAH solution prepared in the section " Reagents " was used instead of the aqueous quaternary ammonium hydroxide solution produced by the above operation.

The concentrations of the amines in the semiconductor treatment liquids were all less than 100 ppm by mass. Further, the concentrations of the alcohols in the semiconductor treatment liquids were all less than 100 ppm by mass.

### <Examples 11 to 15 and Comparative Example 3>

### (Preparation of Semiconductor Treatment Liquid Containing Hypobromite Ion)

Hydrobromic acid and an aqueous quaternary ammonium hydroxide solution were added to a mixed liquid containing the 1.5 mol/L aqueous quaternary ammonium hypochlorite solution and quaternary ammonium hydroxide produced by the above operation to produce a 0.5 mol/L quaternary ammonium hypobromite solution. Ion-exchanged water, hydrobromic acid, and a quaternary ammonium hydroxide solution were added to the resulting aqueous quaternary ammonium hypobromite solution to prepare a treatment liquid having the composition as shown in Table 1.

In Comparative Example 3, however, the aqueous TMAH solution prepared in the section " Reagents " was used instead of the aqueous quaternary ammonium hydroxide solution produced by the above operation.

The concentrations of the amines in the semiconductor treatment liquids were all less than 100 ppm by mass. Further, the concentrations of the alcohols in the semiconductor treatment liquids were all less than 100 ppm by mass.

### <Examples 16 to 20 and Comparative Example 4>

### (Preparation of Semiconductor Treatment Liquid Containing Periodic Acid Compound)

To the aqueous quaternary ammonium hydroxide solution produced by the above operation, orthoperiodic acid or metaperiodic acid was added, and ion-exchanged water and hydroiodic acid were further added to prepare a treatment liquid having the composition as shown in Table 1.

In Comparative Example 4, however, the aqueous TMAH solution prepared in the section " Reagents " was used instead of the aqueous quaternary ammonium hydroxide solution produced by the above operation.

The concentrations of the amines in the semiconductor treatment liquids were all less than 100 ppm by mass. Further, the concentrations of the alcohols in the semiconductor treatment liquids were all less than 100 ppm by mass.

**[Table 1]**

| | Treatment liquid | | | | | | | |
|---|---|---|---|---|---|---|---|---|
| | (A) Quatemary ammonium ion | | (B) Halide ion | | (C) Hydroxide ion | (D) Oxidizing agent | | (E) Water |
| | Type | Content (mass%) | Type | Content (mass%) | Content (mass%) | Type | Content (mol/L) | Content (mass%) |
| Example 1 | ETMA+ | 3.00 | Cl- | 0.30 | 0.06 | H2O2 | 1.5 | 95.14 |
| Example 2 | PTMA+ | 0.50 | Cl- | 0.06 | 0.00006 | H2O2 | 0.10 | 99.40 |
| Example 3 | BTMA+ | 0.05 | Cl- | 0.006 | 0.000006 | H2O2 | 0.01 | 99.93 |
| Example 4 | TBA+ | 7.50 | Cl- | 3.0 | 0.0000006 | H2O2 | 0.10 | 89.40 |
| Example 5 | TPA+ | 53.00 | Cl- | 10.0 | 2.0 | H2O2 | 5.0 | 30.00 |
| Example 6 | ETMA+ | 8.00 | Cl- | 1.5 | 0.17 | ClO | 0.40 | 89.93 |
| Example 7 | PTMA+ | 0.30 | Cl- | 0.07 | 0.00006 | ClO | 0.01 | 99.62 |
| Example 8 | BTMA+ | 35.00 | Cl- | 5.4 | 0.006 | ClO | 1.5 | 5809 |
| Example 9 | ETMA+ | 0.02 | Cl- | 0.004 | 0.000006 | ClO | 0.001 | 99.97 |
| Example 10 | ETMA+ | 7.00 | Cl- | 3.6 | 0.006 | ClO | 1.0 | 88.40 |
| Example 11 | ETMA+ | 1.20 | Br- | 0.40 | 0.054 | BrO | 0.05 | 98.30 |
| Example 12 | PTMA+ | 11.40 | Br- | 4.0 | 0.20 | BrO | 0.50 | 83.90 |
| Example 13 | BTMA+ | 0.14 | Br- | 0.008 | 0.017 | BrO | 0.001 | 99.83 |
| Example 14 | ETMA+ | 0.46 | Br- | 0.08 | 0.054 | BrO | 0.01 | 99.40 |
| Example 15 | ETMA+ | 1.20 | Br- | 0.40 | 0.054 | BrO | 0.05 | 98.30 |
| Example 16 | ETMA+ | 7.80 | I- | 10.0 | 0.000006 | H5IO6 | 0.10 | 82.10 |
| Example 17 | PTMA+ | 1.00 | I- | 0.000001 | 0.0000006 | H5IO6 | 0.01 | 98.99 |
| Example 18 | BTMA+ | 1.00 | I- | 0.001 | 0.0006 | H5IO6 | 0.50 | 98.50 |
| Example 19 | ETMA+ | 1.60 | I- | 1.0 | 0.00006 | HIO4 | 0.10 | 97.30 |
| Example 20 | ETMA+ | 1.00 | I- | 0.000005 | 0.0000006 | HIO4 | 0.01 | 98.99 |
| Comparative Example 1 | TMA+ | 2.50 | Cl- | 0.30 | 0.00006 | H2O2 | 1.5 | 95.70 |
| Comparative Example 2 | TMA+ | 6.70 | Cl- | 1.5 | 0.06 | ClO | 0.40 | 91.34 |
| Comparative Example 3 | TMA+ | 0.39 | Br- | 0.08 | 0.06 | BrO | 0.10 | 99.37 |
| Comparative Example 4 | TMA+ | 1.35 | I- | 1.0 | 0.00006 | H5IO6 | 0.10 | 97.55 |
| Comparative Example 5 | TMA+ | 0.07 | - | - | 0.00006 | H2O2 | 0.01 | 99.92 |

In the table, ETMA+ represents ethyltrimethylammonium ion, PTMA+ represents propyltrimethylammonium ion, BTMA+ represents butyltrimethylammonium ion, TBA+ represents tetrabutylammonium ion, TPA+ represents tetrapropylammonium ion, TMA+ represents tetramethylammonium ion, ClO represents hypochlorite ion (ClO⁻), and BrO represents hypobromite ion (BrO⁻).

**[Table 2]**

| | Target metal | Etching rate (Å/min) | Surface roughness | Toxicity test |
|---|---|---|---|---|
| Example 1 | W | A | A | C |
| Example 2 | W | B | A | C |
| Example 3 | TiN | C | A | C |
| Example 4 | TiN | B | B | B |
| Example 5 | W | A | C | B |
| Example 6 | Ru | A | A | C |
| Example 7 | Ru | B | A | C |
| Example 8 | W | A | B | C |
| Example 9 | Mo | C | A | C |
| Example 10 | Ru | B | A | C |
| Example 11 | W | A | A | C |
| Example 12 | Ru | B | A | C |
| Example 13 | W | C | A | C |
| Example 14 | Mo | B | A | C |
| Example 15 | W | A | A | C |
| Example 16 | Ru | B | B | C |
| Example 17 | Ru | C | C | C |
| Example 18 | Mo | A | B | C |
| Example 19 | Mo | B | A | C |
| Example 20 | Ru | C | B | C |
| Comparative Example 1 | W | A | B | D |
| Comparative Example 2 | Ru | A | B | D |
| Comparative Example 3 | Ru | B | B | D |
| Comparative Example 4 | Ru | B | B | D |
| Comparative Example 5 | TiN | C | D | D |

Examples 1 to 20 were evaluated as C or better in all of the etching rate, the surface roughening, and the toxicity test, whereas all of Comparative Examples 1 to 5 were evaluated as D in the toxicity test. Comparative Example 5 was evaluated as D also in the surface roughening. From the above results, it was shown that the semiconductor treatment liquid according to the embodiment of the present invention can suppress surface roughening after etching and is a low-toxicity semiconductor treatment liquid.

### Reference Signs List

1: Anode
2: Cathode
3: Power supply
4: Anode chamber
5: Raw material chamber
6: Intermediate chamber
7: Cathode chamber
8: Anion exchange membrane
9: Cation exchange membrane

## Claims

1. A semiconductor treatment liquid comprising:
(A) a quaternary ammonium ion represented by formula (1) below;
(B) a halide ion;
(C) a hydroxide ion;
(D) an oxidizing agent; and
(E) water, 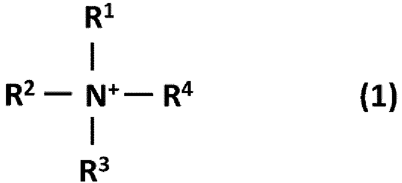
where R¹, R², R³, and R⁴ are each independently an alkyl group having carbon number from 1 to 16, provided that one or more alkyl groups among R¹, R², R³, and R⁴ have carbon number from 2 to 16.

2. The semiconductor treatment liquid according to claim 1, wherein R¹, R², R³, and R⁴ in the formula (1) are not all the same alkyl group.

3. The semiconductor treatment liquid according to claim 1 or 2, wherein R¹, R², and R³ in the formula (1) are methyl groups, and R⁴ in the formula (1) is an alkyl group having carbon number from 2 to 16.

4. The semiconductor treatment liquid according to any one of claims 1 to 3, wherein the halide ion (B) is a chloride ion or a bromide ion.

5. The semiconductor treatment liquid according to any one of claims 1 to 4, wherein a concentration of the halide ion in the semiconductor treatment liquid is from 0.1 ppm by mass to 5.0 mass%.

6. The semiconductor treatment liquid according to any one of claims 1 to 5, wherein an LD₅₀ value converted assuming that an amount of hydroxide of the quaternary ammonium ion is 100 mass%, in a toxicity test using a rat based on an acute oral toxicity test in accordance with OECD Test Guideline 420, is more than 50 mg/kg.

7. The semiconductor treatment liquid according to any one of claims 1 to 6, wherein the oxidizing agent comprises at least one halogen oxyacid ion selected from the group consisting of a hypochlorite ion, a hypobromite ion, and a periodate ion.

8. The semiconductor treatment liquid according to any one of claims 1 to 7, further comprising one or more compounds selected from the group consisting of an alcohol and an amine.

9. A method of using the semiconductor treatment liquid according to any one of claims 1 to 8 as a low-toxicity semiconductor treatment liquid.
